# EUROPEAN PATENT APPLICATION

(11) **EP 1 610 602 A1**
(43) Date of publication of application: **28.12.2005**
(21) Application number: 03789607.3
(22) Date of filing: 18.12.2003
(51) Int. Cl.: H05K 5/02, G11B 33/02

(54) **CASING WITH BOSS FOR ELIMINATING SHARP EDGE**

(30) Priority: 28.03.2003 JP 2003089491
(71) Applicant: SONY CORPORATION, Tokyo 141-0001 (JP)
(72) Inventor: UEMATSU, Hidehiro, Shinagawa-ku, Tokyo 141-0001 (JP); TAKABAYASHI, Satoru, Shinagawa-ku, Tokyo 141-0001 (JP); OKAMOTO, Mitsuhiro, Shinagawa-ku, Tokyo 141-0001 (JP)
(74) Representative: Nicholls, Michael John
(86) International application number: PCT/JP2003/016228
(87) International publication number: WO 2004/089050

(57) **Abstract**

In a casing body 1 of an audio device that includes a main body 2 and a front surface panel 3 formed to protrude outside from an upper surface and side surfaces of the main body 2 and has a sharp edge 43 formed at the corner part 41 of the rear end face of the front surface panel 3, a small boss 45 is formed inside the sharp edge 43. When a finger touches the sharp edge 43, a force concentrated on a point of the sharp edge is dispersed to two points of the sharp edge 43 and the boss 45 due to the provision of the boss 45. Accordingly, even when the finger touches the sharp edge, a fear that the finger is injured is decreased. Since the boss is provided inside the sharp edge, an external appearance as the sharp edge can be maintained in view of its design.

## Description

### Technical Field

The present invention relates to a casing body having a boss for canceling a sharp edge in which the boss (a protrusion) is provided in the vicinity of the sharp edge so as to be safely used without deteriorating an external appearance in the casing body that needs to have the sharp edge in an outer casing part in view of its design.

### Background Art

Ordinarily, a casing body is formed so that a sharp edge cannot be formed in an outer casing part so as to be safely used. However, some casing members may have sharp edges in view of their structures. As a countermeasure to the sharp edge generated in the outer casing part, a method that the sharp edge is hidden by other parts not to touch it, a method that an inclination angle of a corner is increased not to form the sharp edge of an acute angle, or a method that a protruding rib is provided in an inner casing body so as to be flush with the sharp edge of an outer casing body (for instance, refer to Japanese Patent Application Laid-Open No. hei 6-300281 has been mainly employed.

However, the methods for meeting the sharp edge generated in the conventional casing member does not take the external appearance of the sharp edge into consideration. Thus, the above methods cannot be applied to the casing body having a structure that needs to provide the sharp edge on the outer casing part that a user can easily touch in view of its design.

### Disclosure of the Invention

The present invention is devised by considering the above-described problems and it is an object of the present invention to provide a casing body having a boss for canceling a sharp edge that can avoid a risk due to the sharp edge of the casing body formed so as to necessarily provide the sharp edge in an outer casing member that a user can easily touch in view of its design without deteriorating the design.

A casing body having a boss for canceling a sharp edge according to the present invention, in a casing that has the sharp edge in a part with which a hand can easily come into contact in view of its design, wherein a small boss is provided that allows a force concentrated on one point of the sharp edge to escape in the vicinity of the sharp edge.

The casing body according to the present invention is a casing body of an audio device including a main body and a front surface panel having steps in outer sides from an upper surface and side surfaces of the main body, and having the sharp edge formed on a corner part of a rear end face of the front surface panel.

According to the present invention, in the casing body having the sharp edge in a part with which the hand can easily come into contact in view of its design in structure, the small boss that allows the force concentrated on one point of the sharp edge to escape is provided near the sharp edge. Accordingly, even when a user touches the sharp edge, a risk that the user is injured is greatly reduced. Since the boss is provided in the vicinity of the sharp edge so as not to be marked, the external appearance as the sharp edge can be maintained in its design. Further, the boss can be formed only by providing a recessed hole in a metal mold of the casing body, so that it is advantageous in view of cost.

### Brief Description of the Drawings

Fig. 1A is a perspective view showing main parts of a casing body according to an embodiment of the present invention.
Fig. 1B is an enlarged view of a part A in Fig. 1A.
Fig. 2 is a rear face view of a front surface panel.
Fig. 3 is a side view of the front surface panel.
Fig. 4A is an enlarged front view of a sharp edge part on the upper part of the front surface panel.
Fig. 4B is an enlarged side view of the sharp edge part on the upper part of the front surface panel.
Fig. 5A is an enlarged front view of the sharp edge part on the lower part of the front surface panel.
Fig. 5B is an enlarged side view of the sharp edge part on the lower part of the front surface panel.
Fig. 6 is an explanatory view of an operation of a boss of the sharp edge part.

### Best Mode for Carrying Out the Invention

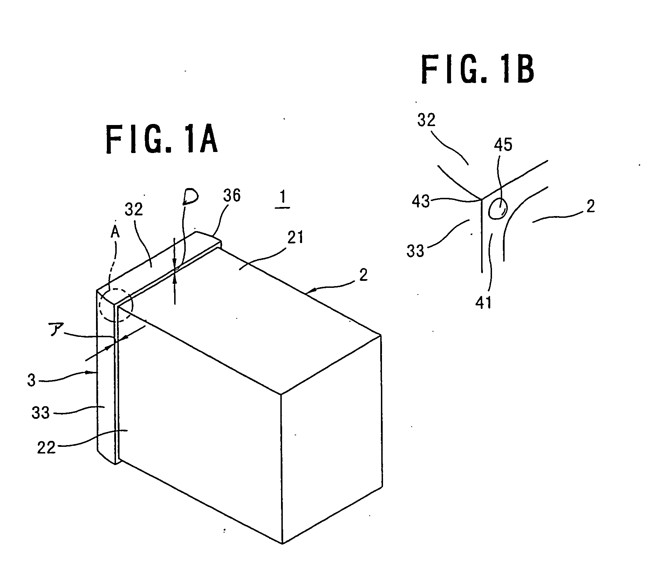

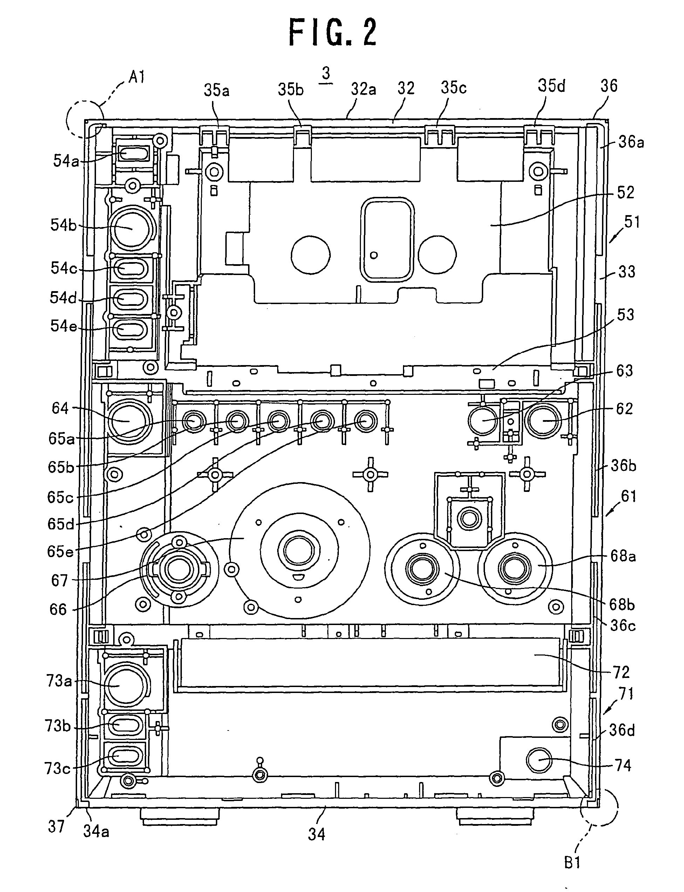

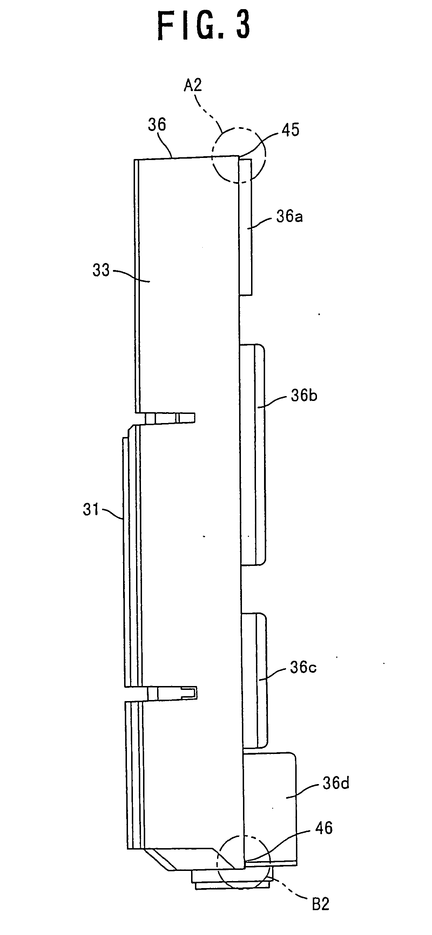

An embodiment of the present invention will be described by referring to the drawings. In Fig. 1, a sharp edge forming part of a casing body of an audio device (a mini component) having a sharp edge according to the present invention is shown in view of its design. In Figs. 2 and 3, a detail of a rear surface and a side surface of a front surface panel of the casing body is shown. The casing body 1 includes a rear cabinet (main body) 2 formed by the press work of a metal plate and a front surface panel 3 formed by a resin mold, as shown in Fig. 1. For the purpose of design, rear ends of an upper surface 32 and side surfaces 33 of the front surface panel 3 protrude outside an upper surface 21 and side surfaces 22 of the main body 2 so that a step D of 1.2 mm is formed between the front surface panel 3 and the main body 2.

Further, as shown in Figs. 2 and 3, the front surface panel 3 include a panel part 31, an upper wall 32, side walls 33 and a bottom wall 34. In the rear end side of the upper wall 32, engaging pieces 35a to 35d are provided that engage with the inside of the upper wall 21 of the main body 2. Further, in the rear end sides of the right and left side walls 33, engaging pieces 36a to 36c are provided that engage with the inside parts of the side walls 22 of the main body 2. R of corner parts 36 and 37 in the upper and lower parts of the side walls 33 of the front surface panel 3 and R of the rear end edges 32a, 33a and 34a of the upper wall 32, the side walls 33 and the bottom wall 34 of the front surface panel 3 are formed substantially to 0 in view of design.

In an upper part 51 of the panel part 31 of the front surface panel 3, a tape record mechanism attaching part 32, a cassette holder attaching part 53 and holes 54a to 54c for tape operating buttons for ejecting, playing, stopping, pausing, recording a tape, etc. are provided. In an intermediate part 61 located in the lower part thereof, a hole 62 for a power button, a hole 63 for an IR operating button, a hole 64 for band switching button, holes 65a to 65e for a mode selecting button, function selecting buttons, etc., a hole 66 for a tuning button, a hole 67 for a sound volume adjusting button, and holes 68a and 68b for low-pitched and high-pitched tone adjusting buttons are provided. In a lower part 71 of the panel part 31, a CD take in and out port 72, holes 73a to 73c for CD operating buttons for playing, pausing, stopping and ejecting a CD, an earphone jack attaching hole 74, etc. are provided.

As described above, in the casing body 1, for the purpose of design, the step of 1.2 mm is formed between the front surface panel 3 and the main body 2. R of the corner parts 36 and 37 of the front surface panel 3 and R of the rear end edges 32a, 33a and 34a of the front surface panel 3 are formed substantially to 0. Thus, the end of a rear end corner part 41 on an upper side formed by the rear end of the upper wall 32 and the rear end of the side wall 33 of the front surface panel 3 forms a sharp edge 43 in view of design. Further, an end of a rear end corner part 42 in a lower side formed by the rear end part of the bottom wall 33 and the rear end of the side wall 32 forms a sharp edge 44 in view of design.

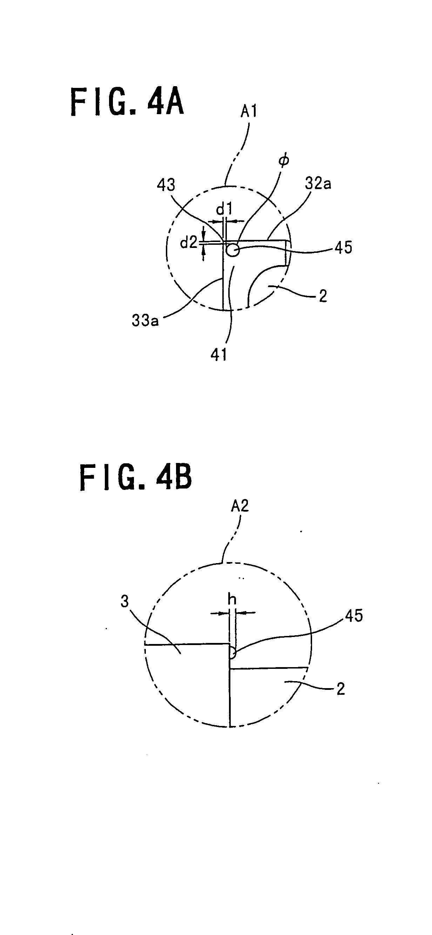

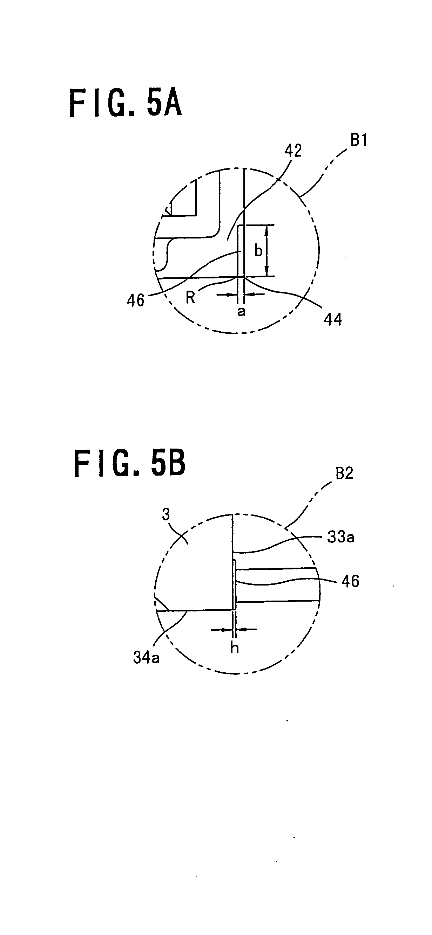

Enlarged views of rear end corner parts A1 and A2 on the upper part of the front surface panel 3 shown in Figs. 2 and 3 are shown in Fig. 4. Enlarged views of rear end corner parts B1 and B2 in the lower part of the front surface panel 3 shown in Figs. 2 and 3 are shown in Fig. 5. In Fig. 4, reference numerals 45 and 46 designate small protrusions (bosses) for canceling the sharp edges that are referred to as "steps" in the present invention. The boss 45 is formed in a semispherical shape having a diameter φ = 0.6 mm and the height of the protrusion h = 0.3 mm at a position separated by 0.1 mm inside the rear end edge 32a of the upper wall 32 and the rear end edge 33a of the side wall 33 that respectively form the sharp edge 43. Further, the boss 46 is formed in a semispherical shape having a width of a = 0.3 mm, a longitudinal length of b = 2.5 mm, the height of the protrusion h = 0.3 mm in a linear form, a lower end part of radius R = 0.15 so as to be located near inside the rear end edge 34a of the bottom wall 34 and the rear end edge 33a of the side wall 33 that form the rear end corner part 42.

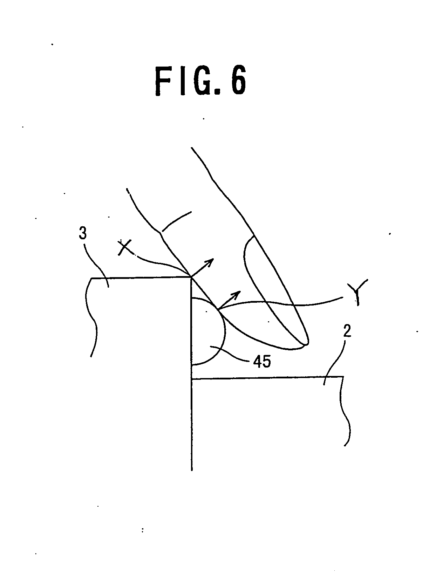

For the purpose of design, a very small semispherical boss 45 is provided inside the sharp edge 45 formed in the rear end corner part 41 of the front surface panel 3. Accordingly, as shown in Fig. 6, when the finger touches the sharp edge 43, the finger touches the boss 45 at the same time. Thus, the force of the finger is exerted on one point X of the sharp edge 43 when the boss 45 does not exist is dispersed to the two points X and Y of the sharp edge 43 and the boss 45. Further, there is a cushion due to the existence of the boss 45, so that a risk that the finger is injured is greatly decreased. Further, since the boss 45 is extremely small as described above, located at the position separate from the edge surface of the sharp edge 43 and hardly marked, the boss does not give an influence to the design of the casing body 1.

Further, the linear small boss 46 is provided in the rear end corner part 42 in the lower side of the front surface panel 3 forming the sharp edge 44. Accordingly, even when the finger touches the sharp edge 46 like the above-described case shown in Fig. 6, the force is dispersed to the two points of the sharp edge 44 and the boss 46 and there is a cushion due to the existence of the boss 46. Thus, a risk that the finger is injured is greatly reduced.

In the casing body 1, when the sharp edges 43 and 44 having the bosses 45 and 46 formed inside thereof are inspected by a sharp tester, the sharp edges are not detected. Further, the boss 46 is linear, however, extremely small, located inside the sharp edge 44 and hardly marked. As a result, the boss 46 hardly gives an influence to the design of the casing body 1.

The reason why the boss 46 is formed in the linear shape is that the metal mold for forming the bottom part 34 of the front surface panel 3 is pulled downward. The form of the boss may be preferably a semispherical like the boss 45.

Since the bosses 45 and 46 protrude on the rear end faces of the front surface panel, the bosses can be formed only by fabricating holes or grooves for forming the bosses on the metal mold that forms the front surface panel 3. Thus, the bosses are fabricated advantageously in view of cost.

### Industrial Applicability.

The above-described embodiment is applied to the casing of the audio device having the sharp edge. However, the present invention is not limited thereto and may be applied to a casing body having a sharp edge from the viewpoint of its design.

## Claims

1. A casing body having a boss for canceling a sharp edge in a casing that has the sharp edge in a part with which a hand can easily come into contact in view of design in a structure, wherein the small boss is provided that allows a force concentrated on one point of the sharp edge to escape in the vicinity of the sharp edge.

2. The casing body having a boss for canceling a sharp edge according to claim 1, wherein the casing body is a casing of an audio device including a main body and a front surface panel having steps in outer sides from an upper surface and side surfaces of the main body, and the sharp edge is formed on a corner part of a rear end face of the front surface panel.

## Amended claims

### Amended claims under Art. 19.1 PCT

**1.** A casing body having a boss for canceling a sharp edge in a casing that has the sharp edge in a part with which a hand can easily come into contact in view of design in a structure, wherein the small boss is provided that allows a force concentrated on one point of the sharp edge to escape in the vicinity of the sharp edge.

**2.** (Canceled)
